# EUROPÄISCHE PATENTSCHRIFT

(11) **EP 2 058 177 B1**
(45) Veröffentlichungstag und Bekanntmachung des Hinweises auf die Patenterteilung: **30.07.2014**
(21) Anmeldenummer: 08105583.2
(22) Anmeldetag: 15.10.2008
(51) Int. Cl.: B60R 7/04, B60R 7/08, B60R 11/02, B60K 37/06

(54) **Bedieneinheit für Vorrichtungen in einem Kraftfahrzeug**
Operating unit for devices in a motor vehicle
Unité de commande pour des dispositifs dans un véhicule automobile

(30) Priorität: 12.11.2007 DE 102007053774
(43) Veröffentlichungstag der Anmeldung: 13.05.2009
(73) Patentinhaber: Ford Global Technologies, LLC, Dearborn, MI 48126 (US)
(72) Erfinder: Spingler, Mark, 50189 Elsdorf (DE); Tsubaki, Erika, 61350 Bad Homburg (DE)
(74) Vertreter: Dörfler, Thomas

(56) Entgegenhaltungen:
- EP-A1- 1 602 521
- WO-A2-2006/045209
- DE-A1- 10 108 141
- DE-A1-102005 038 131
- DE-U1-202004 020 891
- US-A1- 2005 134 072

## Beschreibung

Die vorliegende Erfindung betrifft eine Bedieneinheit für Vorrichtungen in einem Kraftfahrzeug, beispielsweise für Vorrichtungen wie Belüftungsdüsen, der Innenraumbeleuchtung, von Öffnungs- bzw. Schließeinrichtungen für Fenster, etc.

Hierzu ist es insbesondere bekannt, vergleichsweise flache Schaltflächen in Verkleidungselementen des Kraftfahrzeuges unterzubringen, wobei durch Betätigung dieser Schaltflächen geeignete Stellsignale für ein jeweils zugeordnetes Bauteil bzw. Ausstattungselement des Kraftfahrzeuges erzeugbar sind.

Die DE 10 2004 009 189 A1 offenbart hierzu die Verwendung eines verformbaren Trägers einer elektronischen Schaltung mit einer textilen Oberfläche.

Aus der DE 103 26 400 A1 ist ein Bedienelement in einem Fahrzeug zum Betätigen einer Stelleinrichtung bekannt, wobei das Bedienelement eine als drucksensitive Oberfläche ausgebildete Bedienfläche aufweist, durch die in Abhängigkeit von der Position und/oder der Druckintensität eines auf die Bedienfläche ausgeübten Druckes ein Stellsignal erzeugbar ist, durch das das zu verstellende Bauteil über die Stelleinrichtung entsprechend positionierbar ist.

Aus DE 201 03 004 U1 ist es bekannt, ein Gehäuse von elektronischen Geräten so zu gestalten, dass die gesamte Oberfläche als Anzeigeeinrichtung und/oder Bedienoberfläche verwendbar ist. Hierbei sind je nach Bedarf beliebige Teile der Oberfläche, welche z.B. aus LCD, einer flachen biegsamen Folie oder aus einer Plasmafolie bestehen kann, zum Zweck der Anzeige bzw. Bedienung aktivierbar, und die aktivierbare Oberfläche kann vom Benutzer individuell z.B. mittels eines Software-Programmes gesteuert, verändert oder programmiert werden.

Aus der DE 102005038131 ist eine Bedieneinheint nach dem Oberbegriff des Anspruchs 1 bekannt.

Durch die vorstehend diskutierten Lösungen kann die designerische Gestaltungsfreiheit bei der Realisierung von Bedieneinheiten gesteigert werden. Über die wünschenswerte Realisierung neuartiger Designkonzepte hinaus besteht jedoch im Innenraum moderner Kraftfahrzeuge häufig ein Platzproblem, da trotz tendenziell zunehmender Gesamtabmessungen im Fahrzeug neuartige Technologien und Ausstattungsmerkmale realisiert werden und die hierzu erforderlichen Aktivierungselemente einen erheblichen Platz beanspruchen können.

Vor dem obigen Hintergrund ist es eine Aufgabe der vorliegenden Erfindung, eine Bedieneinheit für Vorrichtungen in einem Kraftfahrzeug bereitzustellen, durch welche eine verbesserte Raumausnutzung im Innenraum des Kraftfahrzeuges ermöglicht wird.

Diese Aufgabe wird gemäß den Merkmalen des unabhängigen Anspruchs 1 gelöst.

Dadurch, dass das zur Aufnahme der Bedienelemente bestimmte Trägerelement im Einbauzustand einen Stauraum zur Aufnahme zu verstauender Objekten ausbildet, wird eine verbesserte Raumausnutzung im Innenraum des Kraftfahrzeuges ermöglicht.

Dabei liegt der Erfindung das Konzept zugrunde, dem Trägerelement insofern eine doppelte Tragefunktion zukommen zu lassen, als es zum einen als Träger eines oder mehrerer Bedienelemente dient und zum anderen, etwa in einer Einbauposition am Dachhimmel des Kraftfahrzeuges, die in dem bereitgestellten Stauraum untergebrachten Objekte tragen bzw. aufnehmen kann.

Gemäß einer bevorzugten Ausgestaltung weist das Trägerelement eine wannenartig gewölbte Geometrie auf. Hierdurch kann neben der durch die wannenartige Ausgestaltung bewirkten Stauraumbereitstellung auch eine gewölbte und ergonomisch vorteilhafte Gestalt der den Bedienelementen zugeordneten Bedienflächen erzielt werden.

Weitere Ausgestaltungen sind der Beschreibung sowie den Unteransprüchen zu entnehmen.

Die Erfindung wird nachstehend anhand eines in den beigefügten Abbildungen dargestellten Ausführungsbeispiels näher erläutert.

Es zeigen:
- Figur 1: eine schematische Perspektivansicht einer Bedieneinheit gemäß einer bevorzugten Ausführungsform der Erfindung;
- Figur 2: eine perspektivische Rückansicht der Bedieneinheit von Figur 1 mit einem in einem von dieser Bedieneinheit bereitgestellten Stauraum aufgenommenen Objekt;
- Figur 3: zeigt eine vergrößerte Detailansicht der in Figur 1 dargestellten Bedieneinheit;
- Figur 4: ein Blockschaltbild zur Erläuterung einer in Verbindung mit der erfindungsgemäßen Bedieneinheit vorteilhaft realisierten Elektronikanbindung;
- Figur 5: eine schematische Darstellung zur Erläuterung des Aufbaus einer erfindungsgemäßen Bedieneinheit; und
- Figur 6: eine schematische Darstellung zur Erläuterung des Aufbaus einer unter Verwendung herkömmlicher Schalter realisierten Bedieneinheit.

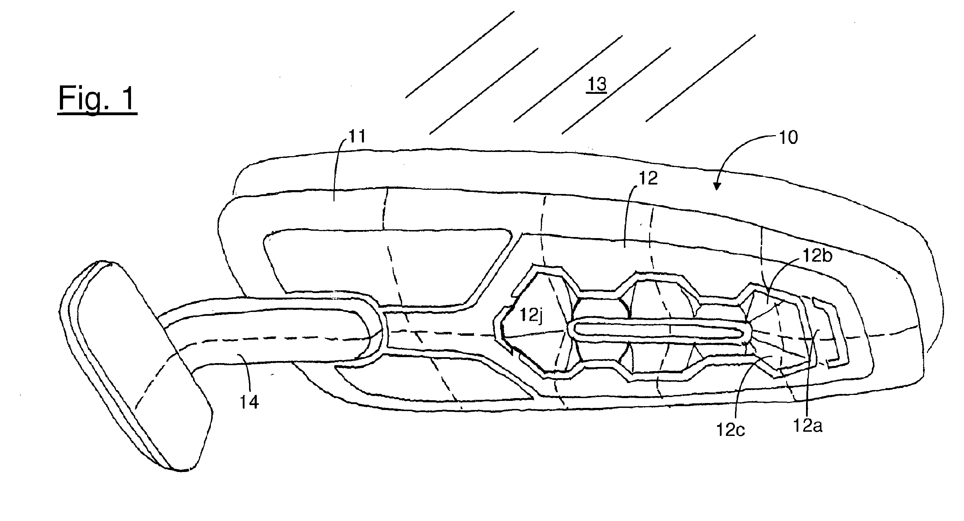

Gemäß Fig. 1 ist eine erfindungsgemäße Bedieneinheit 10 gemäß einer bevorzugten Ausführungsform in perspektivischer Darstellung gezeigt.

Diese Bedieneinheit 10 weist in dem Ausführungsbeispiel ein Trägerelement 11 mit wannenartig gewölbter Geometrie auf, welches zur lösbaren Anbringung am Dachhimmel 13 eines Kraftfahrzeuges ausgestaltet ist. Diese lösbare Anbringung kann in beliebiger Weise, beispielsweise mittels Aufstecken auf eine dachhimmelseitig vorgesehene Halteleiste (nicht dargestellt) oder mittels einer anderen Steckverbindung, realisiert sein. Des Weiteren kann die dem Trägerelement 11 dachhimmelseitig gegenüberliegende Wandung entweder durch die am Dachhimmel 13 vorgesehene Innenraumverkleidung selbst oder auch durch ein an dem Trägerelement 11 sowie an dem Dachhimmel 13 lösbar fixierbares Gegenstück ausgebildet sein. In letztgenanntem Falle kann die Bedieneinheit insbesondere als ein Gehäuse ausgestaltet sein, bei dem das Trägerelement ein abnehmbares, im abgenommenen Zustand das als Stauraum dienende Gehäuseinnere freigebendes Gehäuseteil bildet.

Bestandteil der Bedieneinheit 10 ist weiter eine auf dem Trägerelement 11 vorgesehene, lang gestreckte Bedienfläche 12 mit einer Vielzahl flächiger Bedienelemente 12a, 12b, 12c,..., welche jeweils druck- bzw. berührungssensitiv als resistive Folien-Drucksensoren, sog. FSR-Schaltelemente, ausgestaltet sind, so dass durch Bedienung dieser Bedienelemente 12a, 12b, 12c,..., Stellsignale für jeweils eine zugeordnete Vorrichtung, bei der es sich um ein beliebiges Bauteil oder Ausstattungselement des Kraftfahrzeuges handeln kann, erzeugbar sind.

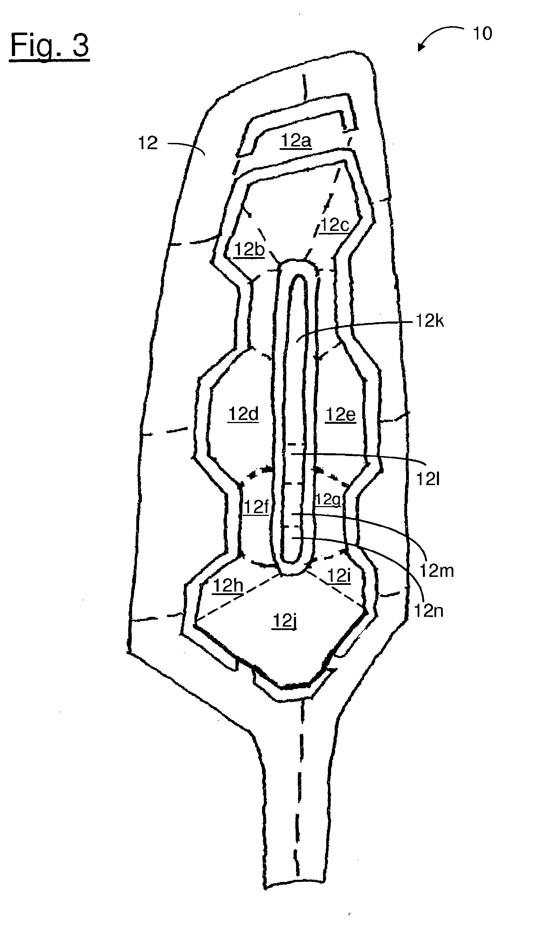

Im Einzelnen umfassen die gemäß dem Ausführungsbeispiel vorgesehenen Bedienelemente gemäß der in Fig. 3 vergrößert dargestellten Anordnung ein Bedienelement 12a zur Ein-/Ausschaltung rückseitiger Parksensoren, Bedienelemente 12b - 12c für Belüftungsdüsen, Bedienelemente 12d-12f zur Garagentorfernbedienung, ein Bedienelement 12g zur Öffnung der Motorhaube, Bedienelemente 12h-12i für den linken bzw. rechten Scheinwerfer, ein Bedienelement 12j für die Innenraumbeleuchtung, ein ein längliches Bedienfeld aufweisendes Bedienelement 12k zur Einstellung der Öffnungsweite eines Schiebedaches, ein Bedienelement 12l zur Einstellung des Kippwinkels des Schiebedaches, ein Bedienelement 12m zur Aktivierung eines Regensensors und ein Bedienelement 12n zur Aktivierung einer elektrischen Abtönung bzw. Abschattung von Umgebungslicht z.B. in einem Panorama-Sonnendach.

Dabei ist insbesondere das dem Schiebedach zugeordnete und mit dem länglichen Bedienfeld ausgestattete Bedienungselement 12k so ausgestaltet, dass dessen Bedienung durch Entlangfahren eines Fingers analog zur Bewegungsrichtung des Schiebedaches erfolgen kann, wodurch eine intuitive und damit besonders komfortable Bedienung ermöglicht wird. Analoge, intuitive Bedienungselemente können z.B. auch zur Ansteuerung der Fensterhebevorrichtungen realisiert werden. Gemäß weiteren Ausgestaltungen kann als Bedienelement auch ein Scroll-Rad z.B. zur Temperatureinstellung der Klimaanlage, gegebenenfalls in Verbindung mit einer z.B. an der Beeineinheit angeordneten digitalen Temperaturanzeige, vorgesehen sein.

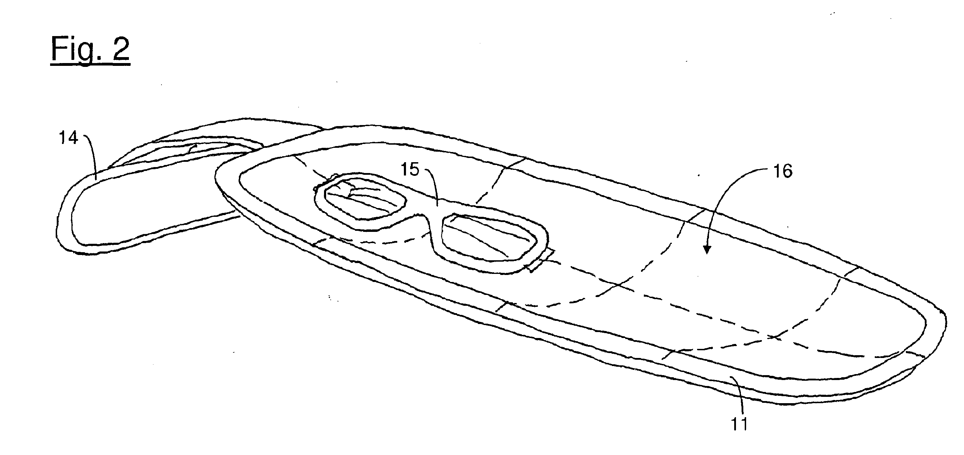

Wie am besten aus Fig. 2 ersichtlich ist, führt die wannenartig gewölbte Ausbildung des Trägerelementes 11 dazu, dass das Bedienelement 10 in seiner Einbauposition am Dachhimmel 13 einen Stauraum 16 für beliebige zu verstauende Objekte 15, beispielsweise gemäß Fig. 2 für eine Sonnenbrille oder auch für Dokumente (wie z.B. Fahrzeugpapiere, Straßenkarten etc.), ausbildet, wobei insbesondere in der hier gewählten Längseinbauposition bezogen auf die Fahrtrichtung (die durch Einzeichnung des Innenspiegels 14 angedeutet ist) ein bequemer und einhändiger Zugriff für den Fahrer oder Beifahrer zum Verstauen bzw. Entnehmen des Objektes aus dem Stauraum 16 erfolgen kann.

Das Trägerelement 11 der erfindungsgemäßen Bedieneinheit 10 besitzt hierbei insofern eine doppelte Tragefunktion, als es zum einen als Träger der flächigen Bedienelemente 12a, 12b, 12c,... dient und zum anderen in der Einbauposition am Dachhimmel 13 die in dem bereitgestellten Stauraum 14 untergebrachten Objekte 15 trägt. Dabei hat die wannenartig gewölbte Ausgestaltung des Trägerelementes 11 neben der hierdurch bewirkten Stauraumbereitstellung auch eine ergonomisch vorteilhafte Gestalt der den Bedienelementen 12a, 12b, 12c,... zugeordneten Bedienflächen zur Folge.

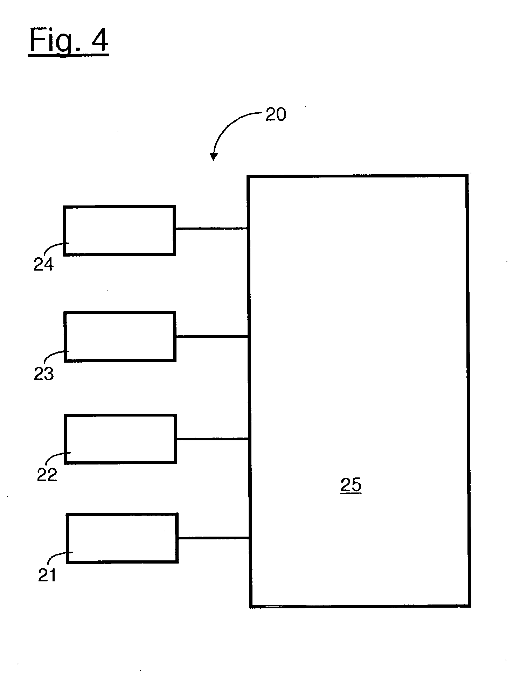

Gemäß Fig. 4 kann ein gemeinsames Elektronikmodul 25 zur Ansteuerung und/oder Versorgung sowohl der erfindungsgemäßen Bedieneinheit 21 als auch weiterer Funktionseinheiten (z.B. ein Beschlagsensor 22 und ein Sonnensensor 23, deren Ausgangssignale jeweils zur Klimasteuerung verwendet werden, und ein Regensensor 24) dienen. Das Elektronikmodul 25 kann ferner beispielsweise auch zur Ansteuerung bzw. Versorgung der Innenraumbeleuchtung oder Außenbeleuchtung dienen. Sämtliche der vorstehend genannten Funktionseinheiten können somit eine gemeinsame elektronische Infrastruktur und ein gemeinsames Kommunikationssystem (beispielsweise eine gemeinsame Leiterplatte und einen gemeinsamen LIN-Knoten) verwenden. Durch die Ausgestaltung gemäß Fig. 4 erzielte Vorteile sind neben der erzielten Platzersparnis auch eine Kostenersparnis infolge einer Reduzierung der erforderlichen Anzahl elektronischer Bauteile wie Kabel, Stecker etc., sowie auch eine verbesserte Diagnosefähigkeit.

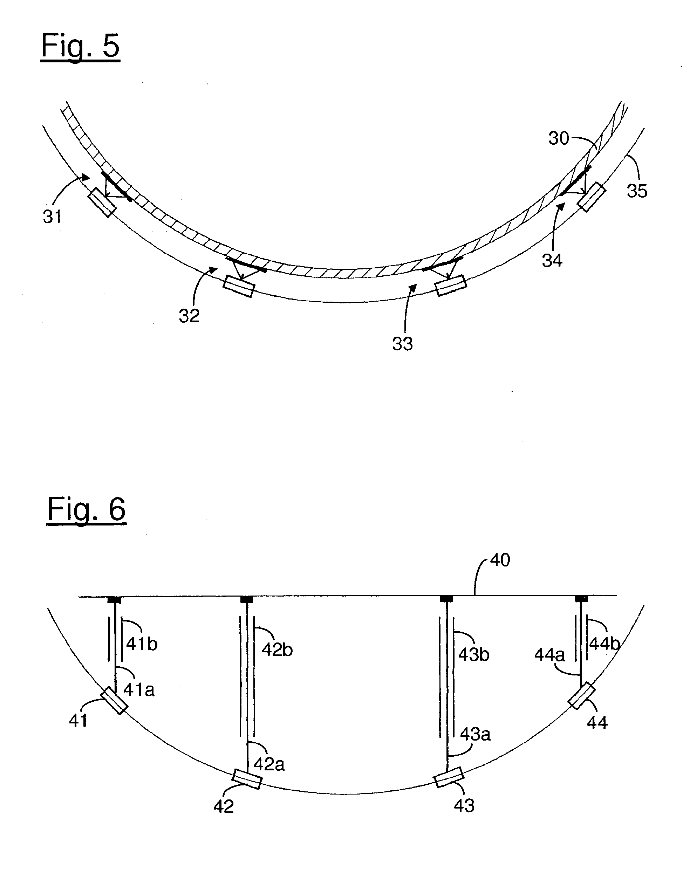

Aus der schematischen Schnittansicht von Fig. 5 wird deutlich, wie die Bereitstellung von zusätzlichem Stauraum durch die erfindungsgemäße Bedieneinheit 10 unter besonderer Ausnutzung der vorteilhaften Eigenschaften der flächigen Bedienelemente 12a, 12b, 12c,... in Form von FSR-Schaltelementen erfolgt. Dabei ist zum Vergleich in Fig. 6 eine Bedieneinheit mit herkömmlichen Schaltern 41, 42, 43 und 44, welche über Schaltkraftübertragungen 41 a, 42a, 43a, 44a und geeignete Führungen 41 b, 42b, 43b und 44b Schaltsignale an eine gedruckte Leiterplatte 40 übertragen, schematisch dargestellt.

Gemäß Fig. 5 weist die erfindungsgemäße Bedieneinheit resistive Folien-Drucksensoren bzw. FSR-Schaltelemente 31 - 34 auf, welche in für sich bekannter Weise bei in Normalrichtung aufgebrachtem mechanischen Druck ihren elektrischen Widerstand ändern und mit vergleichsweise geringen Schaltwegen (typischerweise im Bereich von 0.3 - 0.5 mm) betätigbar sind. Die Folien-Drucksensoren bzw. FSR-Schaltelemente 31 - 34 sind auf einem die geeignete, wannenartig gewölbte Geometrie aufweisenden Substrat 30 angeordnet und weisen zwischen den Schaltfeldern und den eigentlichen FSR-Schaltsegmenten der FSR-Schaltelemente 31 - 34 mechanische Kupplungselemente zur Bereitstellung eines gewissen mechanischen Tasteindruckes (Haptik) auf.

## Patentansprüche

1. Bedieneinheit für Vorrichtungen in einem Kraftfahrzeug, mit:
wenigstens einem Bedienelement zur Erzeugung eines Stellsignals für wenigstens eine Vorrichtung in dem Kraftfahrzeug; und
einem Stauraum zur Aufnahme von im Innenraum des Kraftfahrzeuges zu
verstauenden Objekten,
**dadurch gekennzeichnet, dass**
die Bedieneinheit als Gehäuse mit einem durch ein Trägerelement (11) gebildeten abnehmbaren Gehäuseteil ausgestaltet ist, wobei dieses Gehäuseteil im abgenommenen Zustand das als Stauraum dienende Gehäuseinnere des Gehäuses freigibt; und
wobei das wenigstens eine Bedienelement (12a, 12b, 12c,...) zur Erzeugung des Stellsignals in einer durch einen druck- oder berührungssensitiven Oberflächenbereich dieses Trägerelementes (11) gebildeten Bedienfläche (12) als resistiver Folien-Drucksensor ausgebildet ist.

2. Bedieneinheit nach Anspruch 1,
**dadurch gekennzeichnet, dass**
das wenigstens eine Bedienelement (12a, 12b, 12c,...) derart ausgestaltet ist, dass dessen Bedienung analog zu einer Bewegungsrichtung und/oder Position eines zu verstellenden Bauteiles erfolgt.

3. Bedieneinheit nach Anspruch 1 oder 2,
**dadurch gekennzeichnet, dass**
wenigstens ein Bedienelement (12a, 12b, 12c,...) ein Scroll-Rad ist.

4. Bedieneinheit nach einem der vorhergehenden Ansprüche,
**dadurch gekennzeichnet, dass**
das Trägerelement (11) eine wannenartig gewölbte Geometrie aufweist.

5. Bedieneinheit nach einem der vorhergehenden Ansprüche,
**dadurch gekennzeichnet, dass**
diese zur Montage am Dachhimmel (13) des Kraftfahrzeuges ausgestaltet ist.

6. Bedieneinheit nach einem der vorhergehenden Ansprüche,
**dadurch gekennzeichnet, dass**
das Trägerelement (11) eine lang gestreckte Geometrie aufweist.

7. Bedieneinheit nach einem der vorhergehenden Ansprüche,
**dadurch gekennzeichnet, dass**
auf dem Trägerelement (11) eine Mehrzahl von Bedienelementen (12a, 12b, 12c,...) ausgebildet ist.

## Claims

1. Operator control unit for devices in a motor vehicle, having: at least one operator control element for generating an actuating signal for at least one device in the motor vehicle; and a storage space for holding objects to be stored in the passenger compartment of the motor vehicle, **characterized in that** the operator control unit is embodied as a housing with a removable housing component which is formed by a carrier element (11), wherein in the removed state this housing component clears the interior, serving as storage space, of the housing; and wherein the at least one operator control element (12a, 12b, 12c, ...) for generating the actuating signal is embodied as a resistive film pressure sensor in an operator control face (12) which is formed by a pressure-sensitive or touch-sensitive surface region of this carrier element (11).

2. Operator control unit according to Claim 1, **characterized in that** the at least one operator control element (12a, 12b, 12c, ...) is embodied in such a way that it is operated in a way which is analogous to a movement direction and/or position of a component to be adjusted.

3. Operator control unit according to Claim 1 or 2, **characterized in that** at least one operator control element (12a, 12b, 12c, ...) is a scroll wheel.

4. Operator control unit according to one of the preceding claims, **characterized in that** the carrier element (11) has a geometry which is curved in the manner of a trough.

5. Operator control unit according to one of the preceding claims, **characterized in that** said operator control unit is embodied for mounting on the inner roof lining (13) of the motor vehicle.

6. Operator control unit according to one of the preceding claims, **characterized in that** the carrier element (11) has an elongated geometry.

7. Operator control unit according to one of the preceding claims, **characterized in that** a plurality of operator control elements (12a, 12b, 12c, ...) are formed on the carrier element (11).

## Revendications

1. Unité de commande pour des dispositifs dans un véhicule automobile, comprenant :
au moins un élément de commande destiné à produire un signal de réglage pour au moins un dispositif dans le véhicule automobile ; et
un espace de rangement pour recevoir des objets à ranger dans un espace interne du véhicule automobile,
**caractérisée en ce que**
l'unité de commande est configurée sous forme de boîtier avec une partie de boîtier pouvant être enlevée formée par un élément de support (11), cette partie de boîtier, dans l'état enlevé, libérant l'intérieur du boîtier servant d'espace de rangement ; et
l'au moins un élément de commande (12a, 12b, 12c,...) destiné à produire le signal de réglage étant réalisé en tant que capteur de pression à film résistif dans une surface de commande (12) formée par une région de surface de cet élément de support (11) sensible à la pression ou au contact.

2. Unité de commande selon la revendication 1,
**caractérisée en ce que**
l'au moins un élément de commande (12a, 12b, 12c,...) est configuré de telle sorte que sa commande se produise de manière analogue à une direction de déplacement et/ou une position d'un composant à régler.

3. Unité de commande selon la revendication 1 ou 2,
**caractérisée en ce**
**qu'**au moins un élément de commande (12a, 12b, 12c,...) est une molette de défilement.

4. Unité de commande selon l'une quelconque des revendications précédentes,
**caractérisée en ce que**
l'élément de support (11) présente une géométrie courbée en forme de cuvette.

5. Unité de commande selon l'une quelconque des revendications précédentes,
**caractérisée en ce que**
celle-ci est configurée pour le montage sur un habillage de plafond (13) du véhicule automobile.

6. Unité de commande selon l'une quelconque des revendications précédentes,
**caractérisée en ce que**
l'élément de support (11) présente une géométrie allongée.

7. Unité de commande selon l'une quelconque des revendications précédentes,
**caractérisée en ce**
**qu'**une pluralité d'éléments de commande (12a, 12b, 12c,...) sont réalisés sur l'élément de support (11) .
